# EUROPEAN PATENT APPLICATION

(11) **EP 4 621 878 A1**
(43) Date of publication of application: **24.09.2025**
(21) Application number: 24817464.1
(22) Date of filing: 11.11.2024
(51) Int. Cl.: H01M 4/485, H01M 4/505, H01M 4/525, H01M 10/0525, C30B 29/10, C30B 9/12, C01B 25/45

(54) **HIGH-NICKEL SINGLE CRYSTAL POSITIVE ELECTRODE MATERIAL, PREPARATION METHOD THEREFOR, POSITIVE ELECTRODE SHEET, SECONDARY BATTERY AND ELECTRICAL APPARATUS**

(30) Priority: 29.01.2024 CN 202410120099
(71) Applicant: Tianjin B&M Science And Technology Co., Ltd., Tianjin 300384 (CN)
(72) Inventor: XIAO, Shujie, Tianjin 300384 (CN); WU, Wenxi, Tianjin 300384 (CN); WANG, Zibing, Tianjin 300384 (CN); CHEN, Anqi, Tianjin 300384 (CN); ZHOU, Heng, Tianjin 300384 (CN); GAO, Jiongxin, Tianjin 300384 (CN)
(74) Representative: Ström & Gulliksson AB
(86) International application number: PCT/CN2024/131210
(87) International publication number: WO 2025/161597

(57) **Abstract**

The present application provides a high-nickel single crystal positive electrode material and a production method, a positive electrode sheet, a secondary battery and an electric device thereof. The chemical formula of the high-nickel single crystal positive electrode material is Li₁₊δNiₓM_{y}Q_{1-x-y}O_{2+ε}A_{α}R_{β}X_{γ}, wherein 0.8≤x<1, 0<y≤0.2, 0≤δ≤0.15, 0<ε≤0.2, 0<α≤0.04, 0<β≤0.04, 0≤γ≤0.04, the M element and the Q element each independently include one or more of Mn, Co, Al, Ta, Ti, Nb, Ge, Y, Nb, W, Zr, Ce, Ca, Sr, Sc, V, Cr and Mo; the A element includes one or more of Mg, Ca, Sr, Ba, Ti, Zr, V, Nb, Ta, Mo, W, La, Ce, Sc and Cr; the R element includes one or more of B and P; the X element includes one or more of Na, K, Mn, Mg, Ca, Sr and Al; a molar ratio of surface Ni³⁺ of the high-nickel single crystal positive electrode material is 38%-55%, and a molar ratio of surface lattice oxygen is 7%-15%. The structural defects of the material are significantly reduced, thereby increasing its specific capacity and improving its cycle performance.

## Description

This application claims the priority of Chinese Patent Application No. 202410120099.2, filed with the China National Intellectual Property Administration on January 29, 2024, and titled with "HIGH-NICKEL SINGLE CRYSTAL POSITIVE ELECTRODE MATERIAL AND PRODUCTION METHOD, POSITIVE ELECTRODE SHEET, SECONDARY BATTERY AND ELECTRIC DEVICE THEREOF", which is hereby incorporated by reference in its entirety.

### FIELD

The present disclosure relates to the technical field of lithium-ion batteries, and in particular to a high-nickel single crystal positive electrode material and a production method, a positive electrode sheet, a secondary battery and an electric device thereof.

### BACKGROUND

New energy vehicles are increasingly being used, among which lithium-ion batteries are the core of new energy vehicles, and the positive electrode material is the decisive factor in the lithium-ion battery system. In the existing positive electrode material system, high-nickel single crystal positive electrode materials have the advantages of high specific capacity, high compaction density, and high surface/structural stability, and are thus widely used in the production of lithium-ion batteries. However, when producing high-nickel single crystal positive electrode materials, in order to allow the primary particles to fully grow and separate to form a single crystal form, a high sintering temperature is required during the production process. Due to the poor high-temperature stability of high-nickel single crystal positive electrode materials, the specific capacity and cycle performance of the final material are affected.

### SUMMARY

Based on this, the present application provides a high-nickel single crystal positive electrode material with high specific capacity and excellent cycle performance, a production method, a positive electrode sheet, a secondary battery and an electrical device thereof.

A first aspect of the present application provides a high-nickel single crystal positive electrode material, having a chemical formula of Li_{1+δ}NiₓM_{y}Q_{1-x-y}O_{2+ε}A_{α}R_{β}X_{γ}, wherein 0.8≤x<1, 0<y≤0.2, 0≤δ≤0.15, 0<ε<0.2, 0<α≤0.04, 0<β≤0.04, 0≤γ≤0.04, the M element and the Q element each independently include one or more of Mn, Co, Al, Ta, Ti, Nb, Ge, Y, W, Zr, Ce, Ca, Sr, Sc, V, Cr and Mo; the A element includes one or more of Mg, Ca, Sr, Ba, Ti, Zr, V, Nb, Ta, Mo, W, La, Ce, Sc and Cr; the R element includes one or more of B and P; the X element includes one or more of Na, K, Mn, Mg, Ca, Sr and Al; a molar ratio of surface Ni³⁺ of the high-nickel single crystal positive electrode material is 38%-55%, and a molar ratio of surface lattice oxygen is 7%-15%.

In some embodiments, a primary particle of the high-nickel single crystal positive electrode material has a length expressed as L and a width expressed as W, and W/L is 0.7-0.85;
optionally, L is 1300 nm-2000 nm;
optionally, W is 900 nm-1500 nm.

In some embodiments, in an XRD spectrum of the high-nickel single crystal positive electrode material, the diffraction peak intensities I₍₀₀₃₎ and I₍₁₀₄₎ of crystal plane (003) and crystal plane (104) satisfy a relationship of 1.3≤I₍₀₀₃₎/I₍₁₀₄₎≤2.

A second aspect of the present application provides a method for producing the high-nickel single crystal positive electrode material of the first aspect of the present application, comprising the steps of:
producing a local oxygen supplement flux comprising a basic flux component and an oxidizing component; wherein the oxidizing component generates an oxidizing gas under heating conditions, the elements contained in the basic flux component comprises the A element and R element, and the elements contained in the oxidizing component comprises the X element;
subjecting a powder mixture comprising a lithium source and a precursor to a pre-sintering treatment to produce a pre-sintered material; wherein the precursor has a chemical formula of Ni_{c}MₐQ_{1-c-d}(OH)₂, wherein 0.8≤c<1, 0<d≤0.2, and the M element and the Q element each independently include one or more of Mn, Co, Al, Ta, Ti, Nb, Ge, Y, W, Zr, Ce, Ca, Sr, Sc, V, Cr and Mo;
mixing the local oxygen supplement flux and the pre-sintered material, and placing the mixture in a sample container for a sintering treatment to produce the high-nickel single crystal positive electrode material;
wherein the mass of the local oxygen supplement flux accounts for 0.1%-4% of the mass of the pre-sintered material.

In some embodiments, the oxidizing component includes one or more of peroxide, superoxide, nitrate, nitrite, hypochlorite, chlorate, perchlorate, manganate and permanganate of Z element, and the Z element includes one or more of Li, Na, K, Mg, Ca, Sr and Al; and/or
the basic flux component includes one or more of type a flux and type b flux; the type a flux includes one or more of oxide, hydroxide, carbonate, sulfate, chloride and lithium oxygen compound containing the A element, and the A element includes one or more of Mg, Ca, Sr, Ba, Ti, Zr, V, Nb, Ta, Mo, W, La, Ce, Sc and Cr; the type b flux includes one or more of oxygen-containing acid and oxygen-containing acid salt containing boron or phosphorus element;
optionally, the ratio of the total molar amount of the A element, boron element and phosphorus element contained in the basic flux component to the total molar amount of the Z element contained in the oxidizing component is (0.5-1.5):1.

In some embodiments, the pre-sintering treatment comprises at least one of the conditions (1) to (6):
(1) the lithium source includes one or more of lithium hydroxide monohydrate, anhydrous lithium hydroxide, lithium carbonate, lithium nitrate, lithium oxide, lithium oxalate, lithium fluoride, lithium chloride, lithium acetate, lithium sulfate and lithium phosphate;
(2) a molar ratio of lithium element contained in the lithium source to the total metal element contained in the precursor is (0.95-1.20):1, optionally (1.01-1.11):1;
(3) the pre-sintering treatment is performed at a temperature of 500°C-700°C, optionally 600°C-700°C;
(4) the pre-sintering treatment is performed for 2 h-7 h, optionally 4 h-6 h;
(5) the pre-sintering treatment is performed at a heating rate of 2°C/min-20°C/min, optionally 3°C/min-10°C/min;
(6) the pre-sintering treatment is performed under an atmosphere including one or more of air and oxygen, optionally air.

In some embodiments, the sintering treatment comprises at least one of the conditions (1) to (6):
(1) a stacking depth of the pre-sintered material in the sample container is 1 cm-30 cm, optionally 8 cm-20 cm;
(2) the mass of the local oxygen supplement flux accounts for 0.3%-1.8% of the mass of the pre-sintered material;
(3) the sintering treatment is performed at a temperature of 700°C-1000°C, optionally 750°C-850°C;
(4) the sintering treatment is performed for 6 h-20 h, optionally 10 h-14 h;
(5) the sintering treatment is performed at a heating rate of 2°C/min-15°C/min, optionally 3°C/min-10°C/min;
(6) the sintering treatment is performed under an atmosphere including one or more of air and oxygen, optionally air.

A third aspect of the present application provides a positive electrode sheet, comprising the high-nickel single crystal positive electrode material of the first aspect of the present application or the high-nickel single crystal positive electrode material produced by the method of the second aspect of the present application.

A fourth aspect of the present application provides a secondary battery, comprising the positive electrode sheet of the third aspect of the present application.

A fifth aspect of the present application provides an electrical device, comprising the secondary battery of the fourth aspect of the present application.

The high-nickel single crystal positive electrode material provided above has a molar ratio of surface Ni³⁺ of up to 38%-55%, and a molar ratio of surface lattice oxygen of 7%-15%. During the production process, nickel reduction and lattice oxygen evolution are significantly inhibited, and the structural defects of the material are significantly reduced, thereby increasing its specific capacity and improving its cycle performance.

In the production method of the high-nickel single crystal positive electrode material provided by the present application, the local oxygen supplementation flux used not only has the basic functions of conventional fluxes such as promoting particle growth, adjusting crystal planes and morphology, and reducing sintering temperature, but also comprises the component that is oxidizing and can be decomposed at high temperatures. During the sintering process, the local high oxidizing environment generated by its decomposition can be used to further inhibit nickel reduction and lattice oxygen evolution, so that the obtained high-nickel single crystal positive electrode material has the advantages of reduced defects, optimized particle morphology and crystal structure, and improved electrochemical performance. Furthermore, because the local oxygen supplementation flux reduces the sintering temperature, and its local oxygen supplementation characteristics alleviate the problem of insufficient oxygen supply to the material at the bottom of the sample container, the amount of material in a single sintering can be further increased, thereby achieving the effect of improving production efficiency and reducing costs.

In addition, the amount of local oxygen supplement flux is limited to a range equivalent to that of the doping and coating agents, and no additional washing process is required. It does not comprise precious metal elements and other high-priced transition metal elements, making the additive cost of this method controllable.

### BRIEF DESCRIPTION OF DRAWINGS

In order to more clearly illustrate the technical solutions in the embodiments of the present application and to more completely understand the present application and its beneficial effects, the following is a brief introduction to the drawings required for the description of the embodiments. Apparently, the drawings described below are only some embodiments of the present application, and those skilled in the art can obtain other drawings based on these drawings without making inventive effort.
FIG 1 is an SEM image of the high-nickel single crystal positive electrode material in Example 1.
FIG 2 is an XRD spectrum of the high-nickel single crystal positive electrode material in Example 1.
FIG 3 is a detailed spectrum of Ni2p and O1s in Example 1 and Comparative Example 1.
FIG 4 is a charge and discharge curve of Example 1.
FIG 5 is a cycle performance diagram of Example 1 and Comparative Example 1.

### DETAILED DESCRIPTION

For the ease of understanding of the present disclosure, the present application will be described more fully below with reference to relevant examples. The following provides preferred examples of the present application. However, the present application can be implemented in many different forms and is not limited to the examples described herein. On the contrary, the purpose of providing these examples is to make the understanding of the disclosure of the present application more thorough and comprehensive.

Unless otherwise defined, all technical and scientific terms used herein have the same meaning as those commonly understood by those skilled in the art to which the present application belongs. The terms used herein in the specification of the present application are only for the purpose of describing specific examples and are not intended to limit the present application.

The terms "and/or" and "or/and" used herein include any one of two or more related listed items, and also include any and all combinations of the related listed items, wherein the any and all combinations include any combination of two related listed items, any more related listed items, or all related listed items. It should be noted that when at least three items are connected by at least two conjunctions selected from "and/or" and "or/and", it should be understood that in the present application, the technical solution undoubtedly includes technical solutions connected by "logical and", and also undoubtedly includes technical solutions connected by "logical or".

In the present application, the technical features described in an open manner include closed technical solutions composed of the listed features, and also include open technical solutions containing the listed features.

In the present application, when it comes to numerical ranges, unless otherwise specified, the above numerical ranges are deemed to be continuous and include the minimum and maximum values of the range, as well as each value between such minimum and maximum values. Further, when a range refers to an integer, each integer between the minimum and maximum values of the range is included. In addition, when multiple ranges are provided to describe features or characteristics, the ranges can be merged. In other words, unless otherwise specified, all ranges disclosed herein should be understood to include any and all subranges included therein.

Only some numerical ranges are specifically disclosed herein. However, any lower limit can be combined with any upper limit to form an unspecified range; and any lower limit can be combined with other lower limits to form an unspecified range, and likewise any upper limit can be combined with any other upper limit to form an unspecified range. In addition, each separately disclosed point or single value can itself be combined as a lower limit or upper limit with any other point or single value or with other lower limits or upper limits to form an unspecified range.

The temperature parameters in the present application, unless otherwise specified, allow both constant temperature treatment and treatment within a certain temperature range. The constant temperature treatment allows the temperature to fluctuate within the accuracy range controlled by the instrument. Fluctuations within the range of ±5°C, ±4°C, ±3°C, ±2°C, and ±1°C are allowed.

In the present application, unless otherwise specified, the size, particle size, and diameter generally refer to the average value. In the present application, "particle granularity" and "particle size" have the same definition, both representing the average particle size of a sphere or a spheroid.

Herein, the "suitable" mentioned in "suitable combination", "suitable method", "any suitable method", etc., shall be based on the ability to implement the technical solution of the present application, solve the technical problems of the present application, and achieve the expected technical effects of the present application.

In the present application, "further", "more further", "particularly" and the like are used for descriptive purposes to indicate differences in content, but should not be construed as limiting the scope of protection of the present application.

In the present application, "optionally", "optional", and "option" mean optional or dispensable, that is, any one of the two parallel schemes of "yes" or "no". If multiple "optional" appear in a technical solution, unless otherwise specified and there is no contradiction or mutual restriction, each "optional" is independent.

In the description of the present application, "more" means at least two, such as two, three, etc., unless otherwise clearly and specifically defined.

If there is no special description, all embodiments and optional embodiments of the present application can be combined with each other to form a new technical solution. If there is no special description, all technical features and optional technical features of the present application can be combined with each other to form a new technical solution.

If there is no special description, all the steps of the present application can be performed sequentially or randomly, preferably sequentially.

When producing high-nickel single crystal positive electrode materials, in order to make the primary particles fully grow and separate to form a single crystal form, a high sintering temperature is required during the production process. As a result, the unstable LiNiO₂ structure in the high-nickel laminated material undergoes lattice oxygen evolution accompanied by nickel reduction during the sintering process, leading to structural defects such as cation mixing and inactive phase transition in the crystal structure, which has an adverse effect on the specific capacity and cycle life of the material.

At present, the measures commonly taken by the industry to alleviate the defect problem of high-nickel single crystal materials include: (1) lowering the sintering temperature: using appropriate flux to lower the sintering temperature, thereby inhibiting the lattice oxygen evolution of high-nickel single crystal materials and the structural defects induced by it; (2) ensuring sufficient oxygen supply: using a pure oxygen atmosphere and limiting the loading depth of material during the sintering process to ensure that oxygen can diffuse to the bottom of the sagger, increase the local oxygen concentration, allow the material to fully contact with oxygen, promote the movement of chemical equilibrium, and thus inhibit the lattice oxygen evolution. However, measure (2) will limit the amount of material charged in a single sintering, which is not conducive to increasing production capacity and reducing costs.

The use of common flux in measure (1) cannot solve the problem of insufficient oxygen supply to the material at the bottom of the sagger and limited loading depth. On the contrary, the possible formation of a eutectic by the material at the top may further hinder the diffusion of oxygen to the bottom of the sagger.

Based on the above problems, the present application studies the process parameters such as flux composition, addition amount and material loading amount, and produces a high-nickel single crystal positive electrode material with reduced structural defects, improved particle morphology and crystal structure, and enhanced electrical performance.

A first aspect of the present application provides a high-nickel single crystal positive electrode material, having a chemical formula of Li_{1+δ}NiₓM_{y}Q_{1-x-y}O_{2+ε}A_{α}R_{β}X_{γ}, wherein 0.8≤x<1, 0<y≤0.2, 0≤δ≤0.15, 0<ε≤0.2, 0<α≤0.04, 0<β≤0.04, 0≤γ≤0.04, the M element and the Q element each independently include one or more of Mn, Co, Al, Ta, Ti, Nb, Ge, Y, W, Zr, Ce, Ca, Sr, Sc, V, Cr and Mo; the A element includes one or more of Mg, Ca, Sr, Ba, Ti, Zr, V, Nb, Ta, Mo, W, La, Ce, Sc and Cr; the R element includes one or more of B and P; the X element includes one or more of Na, K, Mn, Mg, Ca, Sr and Al; a molar ratio of surface Ni³⁺ of the high-nickel single crystal positive electrode material is 38%-55%, and a molar ratio of surface lattice oxygen is 7%-15%.

As an example, the molar ratio of surface Ni³⁺ of the high-nickel single crystal positive electrode material may be but not limited to 38%, 38.5%, 39%, 39.5%, 40%, 40.5%, 41%, 41.5%, 42%, 42.5%, 43%, 43.5%, 44%, 44.5%, 45%, 45.5%, 46%, 46.5%, 47%, 47.5%, 48%, 48.5%, 49%, 49.5%, 50%, 50.5%, 51%, 51.5%, 52%, 52.5%, 53%, 53.5%, 54%, 54.5%, 55% or the range between any two of the above values.

The molar ratio of surface lattice oxygen of the high-nickel single crystal positive electrode material may be but not limited to 7%, 7.5%, 8%, 8.5%, 9%, 9.5%, 10%, 10.5%, 11%, 11.5%, 12%, 12.5%, 13%, 13.5%, 14%, 14.5%, 15% or a range between any two of the above values.

Understandably, the high-nickel single crystal positive electrode material provided above has a molar ratio of surface Ni³⁺ of up to 38%-55%, and a molar ratio of surface lattice oxygen of 7%-15%. During the production process, nickel reduction and lattice oxygen evolution are significantly inhibited, and the structural defects of the material are significantly reduced, thereby increasing its specific capacity and improving its cycle performance.

It should be noted that the molar ratio of surface Ni³⁺ and the molar ratio of surface lattice oxygen of the high-nickel single crystal positive electrode material mentioned above can be measured by X-ray photoelectron spectrometer (XPS). The measurement process can be specifically as follows: Al-Kα is used as the ray source (energy hv = 1486.6 eV), and the C1s peak binding energy of 284.80 eV is used as the charge correction standard; the two groups of Ni 2p and O 1s fine spectra are further analyzed, and deconvolution is performed according to the unified characteristic peak position to obtain the relative proportions of the following chemical states, and based on Ni³⁺/(Ni³⁺ + Ni²⁺) and O_{adsorption} /(O_{adsorption} + O_{lattice}), the molar ratio of surface Ni³⁺ and the molar ratio of surface lattice oxygen are calculated; and the ratios of Ni³⁺/(Ni³⁺ + Ni²⁺) and O_{adsorption} /(O_{adsorption} + O_{lattice}) reflect the degree of nickel reduction and lattice oxygen evolution.

In some embodiments, a primary particle of the high-nickel single crystal positive electrode material has a length expressed as L and a width expressed as W, and W/L is 0.7-0.85; for example, it may be but not limited to 0.7, 0.71, 0.72, 0.73, 0.74, 0.75, 0.76, 0.77, 0.78, 0.79, 0.8, 0.81, 0.82, 0.83, 0.84, 0.85 or the range between any two of the above values. When the ratio of length L to width W is within the above range, it indicates that the particle morphology of the high-nickel single crystal positive electrode material is optimized, which is beneficial to improve the reversible capacity and cycle stability of the material.

It should be noted that the primary particles of the high-nickel single crystal positive electrode material are converted into rectangles with equal area and closest shape, where the long side of the rectangle is length L and the short side is width W.

In some optional embodiments, the length L of the primary particles of the high-nickel single crystal positive electrode material is 1300 nm-2000 nm; for example, it may be but not limited to 1300 nm, 1350 nm, 1400 nm, 1450 nm, 1500 nm, 1550 nm, 1600 nm, 1650 nm, 1700 nm, 1750 nm, 1800 nm, 1850 nm, 1900 nm, 1950 nm, 2000 nm or the range between any two of the above lengths. When the length L is within the above range, the contact area between the high-nickel single crystal positive electrode material particles and the electrolyte is appropriate, which is sufficient for lithium ions to undergo intercalation/deintercalation reactions, and can avoid excessive side reactions on the surface, thereby improving the cycle performance of the battery.

As a possible embodiment, the length L of the primary particles of the high-nickel single crystal positive electrode material is 900 nm-1500 nm; for example, it may be but not limited to 900 nm, 950 nm, 1000 nm, 1050 nm, 1100 nm, 1150 nm, 1200 nm, 1250 nm, 1300 nm, 1350 nm, 1400 nm, 1450 nm, 1500 nm or the range between any two of the above lengths. When the width W is within the above range, the contact area between the high-nickel single crystal positive electrode material particles and the electrolyte is appropriate, which is sufficient for lithium ions to undergo intercalation/deintercalation reactions, and can avoid excessive side reactions on the surface, thereby improving the cycle performance of the battery.

As an example, the length L, width W and width-to-length ratio W/L of the primary particles of the high-nickel single crystal positive electrode material mentioned above can be measured using a field emission scanning electron microscope.

In some embodiments, in an XRD spectrum of the high-nickel single crystal positive electrode material, the diffraction peak intensities I₍₀₀₃₎ and I₍₁₀₄₎ of crystal plane (003) and crystal plane (104) satisfy a relationship of 1.3≤I₍₀₀₃₎/I₍₁₀₄₎≤2. As an example, I₍₀₀₃₎/I₍₁₀₄₎ may be but not limited to 1.3, 1.4, 1.5, 1.6, 1.7, 1.8, 1.9, 2 or a range between any two of the above values. When I₍₀₀₃₎/I₍₁₀₄₎ is within the above range, it indicates that the crystal structure of the high-nickel single crystal positive electrode material is effectively optimized, which is beneficial to improve the reversible capacity and cycle stability of the material.

It should be noted that the above-mentioned I₍₀₀₃₎ and I₍₁₀₄₎ can be measured by powder X-ray diffraction. The specific process of the measurement can be as follows: Cu-Kα rays are used as the ray source, with a wavelength of 0.154 nm (Kα2 is not removed from the test data), an acceleration voltage and current are 40 kV and 100 mA respectively. Scanning is performed at a rate of 5°/min in the range of 10°-80°, and the area ratio I₍₀₀₃₎/I₍₁₀₄₎ of the (003) peak to the (104) peak in the obtained curve is calculated.

A second aspect of the present application provides a method for producing the high-nickel single crystal positive electrode material of the first aspect of the present application, comprising the steps of:
producing a local oxygen supplement flux comprising a basic flux component and an oxidizing component; wherein the oxidizing component generates an oxidizing gas under heating conditions, the elements contained in the basic flux component comprises A element and R element, and the elements contained in the oxidizing component comprises X element;
subjecting a powder mixture comprising a lithium source and a precursor to a pre-sintering treatment to produce a pre-sintered material; wherein the precursor has a chemical formula of Ni_{c}MₐQ_{1-c-d}(OH)₂, wherein 0.8≤c<1, 0<d≤0.2, and the M element and the Q element each independently include one or more of Mn, Co, Al, Ta, Ti, Nb, Ge, Y, W, Zr, Ce, Ca, Sr, Sc, V, Cr and Mo;
mixing the local oxygen supplement flux and the pre-sintered material, and placing the mixture in a sample container for a sintering treatment to produce the high-nickel single crystal positive electrode material; wherein the mass of the local oxygen supplement flux accounts for 0.1%-4% of the mass of the pre-sintered material.

It should be noted that the basic flux component is a substance that has the functions of promoting particle growth, adjusting particle shape, lowering sintering temperature, etc. Adding the basic flux during the production process can promote particle growth, adjust particle shape, lower sintering temperature, etc.

Understandably, the local oxygen supplementation flux used not only has the basic functions of conventional fluxes such as promoting particle growth, adjusting crystal planes and morphology, and reducing sintering temperature, but also comprises a component that is oxidizing and can be decomposed at high temperatures. During the sintering process, the local high oxidizing environment generated by the decomposition of such component can be used to further inhibit nickel reduction and lattice oxygen evolution, so that the obtained high-nickel single crystal positive electrode material has the advantages of reduced defects, optimized particle morphology and crystal structure, and improved electrochemical performance. Furthermore, because the local oxygen supplementation flux reduces the sintering temperature, and its local oxygen supplementation characteristics alleviate the problem of insufficient oxygen supply to the material at the bottom of the sample container, the amount of material in a single sintering can be further increased, thereby achieving the effect of improving production efficiency and reducing costs.

In addition, the amount of local oxygen supplement flux is limited to a range equivalent to that of the doping and coating agents, and no additional washing process is required. It does not contain precious metal elements and other high-priced transition metal elements, making the additive cost of this method controllable.

As an example, the mass of the local oxygen supplement flux may account for, but not limited to, 0.1%, 0.5%, 1%, 1.5%, 2%, 2.5%, 3%, 3.5%, 4%, or a range between any two of the above values of the mass of the pre-sintered material. When the amount of the local oxygen supplement flux is within the above range, it can decompose and generate oxidizing gas during the sintering process, solving the problem that oxygen is difficult to diffuse to the surface of the material (especially the material at the bottom of the container), providing with sufficient oxygen concentration, effectively inhibiting nickel reduction and lattice oxygen evolution, reducing defects, optimizing particle morphology and crystal structure, and improving electrochemical performance; in addition, it can also help avoid the problem of reduced electrochemical performance caused by excessive electrochemical inert residues.

As an example, during sintering, the mass of the local oxygen supplement flux may account for, but not limited to, 0.4%-1.8%, 0.8%-1.8%, 1.2%-1.8%, 0.4%-1.2%, 0.8%-1.2% or 0.4%-0.8% of the mass of the pre-sintered material.

As a possible embodiment, the basic flux component includes one or more of type a flux and type b flux; the type a flux includes one or more of oxide, hydroxide, carbonate, sulfate, chloride and lithium oxygen compound containing the A element, and the A element includes one or more of Mg, Ca, Sr, Ba, Ti, Zr, V, Nb, Ta, Mo, W, La, Ce, Sc and Cr; the type b flux includes one or more of oxygen-containing acid and oxygen-containing acid salt containing boron or phosphorus element.

In some embodiments, the ratio of the total molar amount of the A element, boron element and phosphorus element contained in the basic flux component to the total molar amount of the Z element contained in the oxidizing component is (0.5-1.5):1; for example, it may be but not limited to 0.5:1, 0.6:1, 0.7:1, 0.8:1, 0.9:1, 1:1, 1.1:1, 1.2:1, 1.3:1, 1.4:1, 1.5:1 or the range between any two of the above ratios. Thus, the basic flux component and the oxidizing component in the local oxygen supplement flux are both kept at appropriate ratios, so as to respectively play the above-mentioned roles, thereby achieving the beneficial effects of reducing the sintering temperature and improving the electrochemical performance.

In some optional embodiments, the oxidizing component includes one or more of peroxide, superoxide, nitrate, nitrite, hypochlorite, chlorate, perchlorate, manganate and permanganate of Z element, and the Z element includes one or more of Li, Na, K, Mg, Ca, Sr and Al.

In some embodiments, during the pre-sintering treatment, the lithium source includes one or more of lithium hydroxide monohydrate, anhydrous lithium hydroxide, lithium carbonate, lithium nitrate, lithium oxide, lithium oxalate, lithium fluoride, lithium chloride, lithium acetate, lithium sulfate and lithium phosphate.

In some exemplary embodiments, during the pre-sintering treatment, the molar ratio of lithium element contained in the lithium source to the total metal element contained in the precursor is (0.95-1.20):1; for example, it may be but not limited to 0.95:1, 0.97:1, 1:1, 1.03:1, 1.05:1, 1.08:1, 1.1:1, 1.13:1, 1.15:1, 1.18:1, 1.2:1 or a range between any two of the above ratios. Optionally, the molar ratio of lithium element contained in the lithium source to the total metal element contained in the precursor is (1.01-1.11):1.

In some of the embodiments, during the pre-sintering treatment, the pre-sintering treatment is performed at a temperature of 500°C-700°C; for example, it may be but not limited to 500°C, 530°C, 550°C, 570°C, 600°C, 630°C, 650°C, 680°C, 700°C or a range between any two of the above temperatures. Optionally, the temperature of the pre-sintering treatment is 600°C-700°C. When the temperature of the pre-sintering treatment is within the above range, the moisture in the material can be fully removed in advance to increase its density, thereby increasing the material loading and yield in the subsequent sintering process and increasing the production capacity. Optionally, the temperature of the pre-sintering treatment is 600°C-700°C.

As a possible embodiment, during the pre-sintering treatment, the pre-sintering treatment is performed for 2 h-7 h; for example, it may be but not limited to 2 h, 3 h, 4 h, 5 h, 6 h, 7 h or a range between any two of the above times. Optionally, the pre-sintering treatment is performed for 4 h-6 h.

In some optional embodiments, during the pre-sintering treatment, the pre-sintering treatment is performed at a heating rate of 2°C/min-20°C/min; for example, it may be but not limited to 2°C/min, 5°C/min, 7°C/min, 10°C/min, 13°C/min, 15°C/min, 18°C/min, 20°C/min or a range between any two of the above heating rates. Optionally, the pre-sintering treatment is performed at a heating rate of 3°C/min-10°C/min.

In some embodiments, the pre-sintering treatment is performed under an atmosphere including one or more of air and oxygen. Optionally, the pre-sintering treatment is performed under an atmosphere of air.

As an example, the air is dry air.

It should be noted that the temperature, time, heating rate and atmosphere of the pre-sintering treatment can be combined in any appropriate manner, and the four can be selected from any pre-sintering treatment temperature, time, heating rate and atmosphere described herein.

In some embodiments, during the sintering treatment, a stacking depth of the pre-sintered material in the sample container is 1 cm-30 cm, which increases the sample loading amount, thereby achieving the effect of improving production efficiency and reducing costs. As an example, the stacking depth may be but not limited to 1 cm, 2 cm, 3 cm, 4 cm, 5 cm, 6 cm, 7 cm, 8 cm, 9 cm, 10 cm, 11 cm, 12 cm, 13 cm, 14 cm, 15 cm, 16 cm, 17 cm, 18 cm, 19 cm, 20 cm, 21 cm, 22 cm, 23 cm, 24 cm, 25 cm, 26 cm, 27 cm, 28 cm, 29 cm, 30 cm or a range between any two of the above depths.

As an example, the stacking depth of the pre-sintered material in the sample container may be but not limited to 9 cm-18 cm, 12 cm-18 cm, 6 cm-18 cm, 6 cm-12 cm, 6 cm-9 cm or 9 cm-12 cm.

As an example, the stacking depth of the mixed material of the local oxygen supplement flux and the pre-sintered material in the sample container may be but not limited to 9 cm-18 cm, 12 cm-18 cm, 6 cm-18 cm, 6 cm-12 cm, 6 cm-9 cm or 9 cm-12 cm.

Optionally, the stacking depth of the pre-sintered material in the sample container is 8 cm-20 cm. Further optionally, the stacking depth of the pre-sintered material in the sample container is 9 cm-18 cm. More optionally, the stacking depth of the pre-sintered material in the sample container is 12 cm-18 cm.

Optionally, the stacking depth of the mixed material of the local oxygen supplement flux and the pre-sintered material in the sample container is 8 cm-20 cm. Further optionally, the stacking depth of the mixed material of the local oxygen supplement flux and the pre-sintered material in the sample container is 9 cm-18 cm. More optionally, the stacking depth of the mixed material of the local oxygen supplement flux and the pre-sintered material in the sample container is 12 cm-18 cm.

During the sintering process, compared with the case where no oxidizing components are added, the addition of a local oxygen supplement flux can reduce defects by inhibiting the evolution of lattice oxygen. Under the premise that the sintered products have the same degree of defects (surface nickel valence state ratio, lattice oxygen ratio, (003)/(104) peak intensity ratio), the stacking depth of raw materials can be increased by 5 cm-12 cm, thereby improving production efficiency. When the stacking depth is ≥8 cm, and other conditions are the same, compared with the case where no oxidizing components are added, the molar ratio of surface Ni³⁺, calculated by analyzing the X-ray photoelectron spectroscopy (XPS) data, increases by 5%-20%, and the molar ratio of surface lattice oxygen increases by 2%-10%.

As a possible embodiment, the sample container is a sagger.

In some optional embodiments, during the sintering treatment, the mass of the local oxygen supplement flux accounts for 0.3%-1.8% of the mass of the pre-sintered material.

As a possible implementation, during the sintering treatment, the temperature of the sintering treatment is 700°C-1000°C; for example, it may be but not limited to 700°C, 750°C, 800°C, 850°C, 900°C, 950°C, 1000°C or a range between any two of the above temperatures. When the temperature of the sintering treatment is within the above range, the primary particles can be fully grown and separated to form a single crystal form, and when the particle size is within the above range, nickel reduction and lattice oxygen evolution caused by excessive sintering temperature can be avoided. Optionally, the temperature of the sintering treatment is 750°C-850°C.

As an example, during the sintering treatment, the temperature of the sintering treatment may be 800°C-840°C, 800°C-820°C or 820°C-840°C, without specific limitation.

It should be noted that, compared with the case where no local oxygen supplement flux is added, when other conditions are the same, the addition of local oxygen supplement flux can reduce the sintering temperature by 50°C-100°C through its effect of promoting growth and regulating growth direction, optimize the particle morphology and crystal structure of the high-nickel single crystal material, improve the reversible capacity and cycle stability, and reduce processing costs.

In some optional embodiments, during the sintering treatment, the time of the sintering treatment is 6 h-20 h; for example, it may be but not limited to 6 h, 7 h, 8 h, 9 h, 10 h, 11 h, 12 h, 13 h, 14 h, 15 h, 16 h, 17 h, 18 h, 19 h, 20 h or a range between any two of the above times. When the time of the sintering treatment is within the above range, the primary particles can be fully grown and separated to form a single crystal form, and the particle size is within the above range. Optionally, the time of the sintering treatment is 10 h-14 h.

In some exemplary embodiments, during the sintering treatment, the heating rate of the sintering treatment is 2°C/min-15°C/min; for example, it may be but not limited to 2°C/min, 5°C/min, 7°C/min, 10°C/min, 13°C/min, 15°C/min, or a range between any two of the above heating rates. Optionally, the heating rate of the sintering treatment is 3°C/min-10°C/min.

In some embodiments, the atmosphere of the sintering treatment includes one or more of air and oxygen. Optionally, the atmosphere of the sintering treatment is air. Further optionally, the atmosphere of the sintering treatment is dry air.

It should be noted that the temperature, time, heating rate and atmosphere of the sintering treatment can be combined in any appropriate manner, and the four can be selected from any sintering treatment temperature, time, heating rate and atmosphere described herein.

A third aspect of the present application provides a positive electrode sheet, comprising the high-nickel single crystal positive electrode material of the first aspect or the high-nickel single crystal positive electrode material produced by the production method of the second aspect.

A fourth aspect of the present application provides a secondary battery, comprising the positive electrode sheet of the third aspect.

The secondary battery of the present application comprises the above-mentioned high-nickel single crystal positive electrode material, and has a high specific capacity and excellent cycle performance.

A fifth aspect of the present application provides an electric device, comprising the secondary battery of the fourth aspect. The electric device can be an electric car, an electric bicycle, an electric two-wheeled vehicle, an electric car power system, an energy storage system or a mobile storage device, without specific limitation.

The electric device of the present application comprises the secondary battery provided by the present application, and thus has at least the same advantages as the secondary battery.

The technical solutions of the present disclosure are described in detail below in conjunction with specific examples. It should be understood that these examples are only used to illustrate the present disclosure and are not intended to limit the scope of the present disclosure. The experimental methods for which specific conditions are not specified in the following embodiments are preferably referred to the guidance given in the present disclosure, and can also be carried out according to the experimental manual or conventional conditions in the art, or according to the conditions recommended by the manufacturer, or with reference to experimental methods known in the art.

In the following specific examples, the measured parameters of raw material components may have slight deviations within the range of weighing accuracy unless otherwise specified. For temperature and time parameters, acceptable deviations caused by instrument test accuracy or operation accuracy are allowed.

### I. Production of high-nickel single crystal positive electrode material

### Example 1

Step S1. The basic flux components Sr(OH)₂, H₃BO₃ and (NH₄)₂HPO₄ and oxidizing components Li₂O₂ and LiClO₄ were weighed at an amount calculated according to the atomic molar ratio of Sr, B, P, Li and Li being 1:1:1:2:2, and mixed evenly to obtain a local oxygen supplement flux.

Step S2. 913.31 g of lithium source LiOH·H₂O and 1933.58 g of precursor Ni_{0.9}Co_{0.05}Mn_{0.05}(OH)₂ were weighed according to a molar ratio of 1.06:1 of the lithium element in the lithium source and the total metal element contained in the precursor, stirred and mixed at 3000 rpm for 4 min in a mixing device to obtain a uniformly mixed material. The uniformly mixed material was loaded into a sagger and placed in a sintering furnace for pre-sintering treatment. The pre-sintered product was crushed to obtain a pre-sintered material. For the pre-sintering treatment, the temperature was 625°C, the time was 6 h, the heating rate was 3°C/min, the atmosphere was dry compressed air, and the gas flow rate was 3 L/min.

Step S3. The local oxygen supplement flux with a mass of 0.8% of the mass of the pre-sintered material was added, stirred and mixed at 2000 rpm in a mixing device for 4 min, and divided into a sagger of appropriate size so that the material depth was 12 cm. The sagger was placed into a sintering furnace for sintering treatment to obtain a high-nickel single crystal positive electrode material. For the sintering treatment, the temperature was 820°C, the time was 10 h, the heating rate was 5°C/min, the atmosphere was pure oxygen (oxygen content ≥97%), and the gas flow rate was 4 L/min. The sintered product was crushed and sieved to obtain the product, which was subjected to physical and chemical characterization and electrochemical performance tests.

### Example 2

Example 2 differs from Example 1 in that the temperature of the sintering treatment in step S3 was 800° C, and the rest was the same.

### Example 3

Example 3 differs from Example 1 in that the temperature of the sintering treatment in step S3 was 840° C, and the rest was the same.

### Example 4

Example 4 differs from Example 3 in that the mass of the local oxygen supplement flux added in step S3 was 1.2% of the mass of the pre-sintered material, and the rest was the same.

### Example 5

Example 5 differs from Example 3 in that the mass of the local oxygen supplement flux added in step S3 was 0.4% of the mass of the pre-sintered material, and the rest was the same.

### Example 6

Example 6 differs from Example 1 in that the depth of the material in the sagger in step S3 was 9 cm, and the rest was the same.

### Example 7

Example 7 differs from Example 1 in that the depth of the material in the sagger in step S3 was 6 cm, and the rest was the same.

### Example 8

Example 8 differs from Example 1 in Step S1: the basic flux components BaCO₃, TiO₂ and LiBO₂ and oxidizing components LiNO₃ and NaNO₃ were weighed at an amount calculated according to the atomic molar ratio of Ba, Ti, B, Li and Na being 1:1:1:2:2, and mixed evenly to obtain a local oxygen supplement flux. The rest was the same.

### Example 9

Example 9 differs from Example 1 in Step S1: the basic flux components Mg(OH)₂, ZrO₂ and Li₃PO₄ and oxidizing components KMnO₄ and NaClO₄ were weighed at an amount calculated according to the atomic molar ratio of Mg, Zr, P, K and Na being 1:1:1:2:2, and mixed well to obtain a local oxygen supplement flux. The rest was the same.

### Example 10

Example 10 differs from Example 1 in Step S1: the basic flux components Sr(OH)₂, H₃BO₃ and (NH₄)₂HPO₄ and oxidizing components Li₂O₂ and Na₂O₂ were weighed at an amount calculated according to the atomic molar ratio of Sr, B, P, Li and Na being 1:1:1:2:2, and mixed evenly to obtain a local oxygen supplement flux. The rest was the same.

### Example 11

Example 11 differs from Example 1 in Step S1: the basic flux components Sr(OH)₂, H₃BO₃ and (NH₄)₂HPO₄ and oxidizing components Li₂O₂ and LiNO₃ were weighed at an amount calculated according to the atomic molar ratio of Sr, B, P, Li and Li being 1:1:1:2:2, and mixed evenly to obtain a local oxygen supplement flux. The rest was the same.

### Example 12

Example 12 differs from Example 1 in that the mass of the local oxygen supplement flux added in step S3 was 1.8% of the mass of the pre-sintered material, and the rest was the same.

### Example 13

Example 13 differs from Example 1 in that the depth of the material in the sagger in step S3 was 18 cm, and the rest was the same.

### Comparative Example 1

Comparative Example 1 differs from Example 1 in that no flux was added in step S3 and the sintering temperature was 880° C. The rest was the same.

### Comparative Example 2

Comparative Example 2 differs from Example 1 in that no oxidizing component was added when producing the flux in step S1, the temperature of the sintering treatment in step S3 was 840°C, and the depth of the material in the sagger was 12 cm. The rest was the same.

### Comparative Example 3

Comparative Example 3 differs from Example 1 in that no oxidizing component was added when producing the flux in step S1, the temperature of the sintering treatment in step S3 was 840°C, and the depth of the material in the sagger was 6 cm. Others are the same.

### Comparative Example 4

Comparative Example 4 differs from Example 1 in that no oxidizing component was added when producing the flux in step S1. The rest was the same.

### Comparative Example 5

Comparative Example 5 differs from Example 1 in that no oxidizing component was added when producing the flux in step S1, and the temperature of the sintering treatment in step S3 was 800° C. The rest was the same.

### Comparative Example 6

Comparative Example 6 differs from Example 1 in that the mass of the local oxygen supplement flux added in step S3 was 5.0% of the mass of the pre-sintered material, and the rest was the same.

### II. Characterization of the morphology, size and crystal structure of positive electrode materials

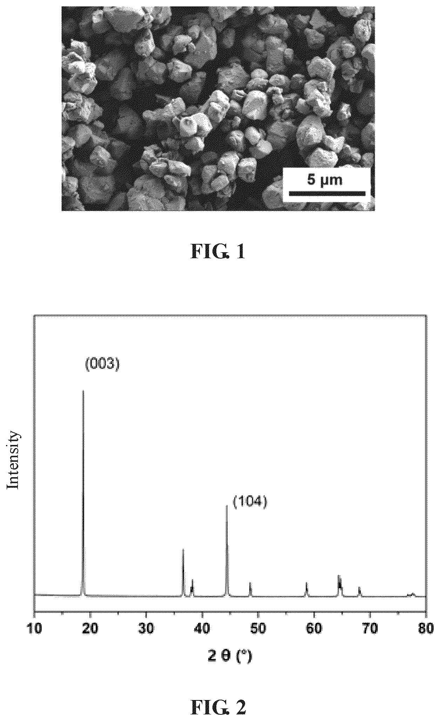

The positive electrode material was observed using a field emission scanning electron microscope, and the length L and width W of each visible primary particle were measured and recorded for the micrographs of appropriate magnification (the particles were converted into rectangles of equal area and closest shape, with the long side of the rectangle being the length L and the short side being the width W), and the ratio W/L was calculated. The test results of Examples 1-11 and Comparative Examples 1-5 are shown in Table 1. The observation results of Example 1using the scanning electron microscope are shown in FIG 1. As can be seen from FIG 1, the primary particles of the high-nickel single crystal positive electrode material obtained in Example 1 had fully grown to a suitable size range and separated.

The positive electrode material was tested by a powder X-ray diffractometer, using Cu-Kα rays as the ray source, with a wavelength of 0.154 nm (Kα2 was not removed from the test data), an accelerating voltage and current were 40 kV and 100 mA, respectively, and scanning was performed at a rate of 5°/min in the range of 10°-80°. The area ratio I₍₀₀₃₎/I₍₁₀₄₎ of the (003) peak to the (104) peak in the curve was calculated. The test results of Examples 1-11 and Comparative Examples 1-5 are shown in Table 1. The XRD spectrum of Example 1 is shown in FIG 2. As can be seen from FIG 2, the high-nickel single crystal positive electrode material produced in Example 1 had a typical α-NaFeO2-type layered crystal structure, belonging to the hexagonal system and R-3m space group, and the two strongest diffraction peaks were the (003) crystal plane peak near 18.7° and the (104) crystal plane peak near 44.3°.

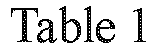

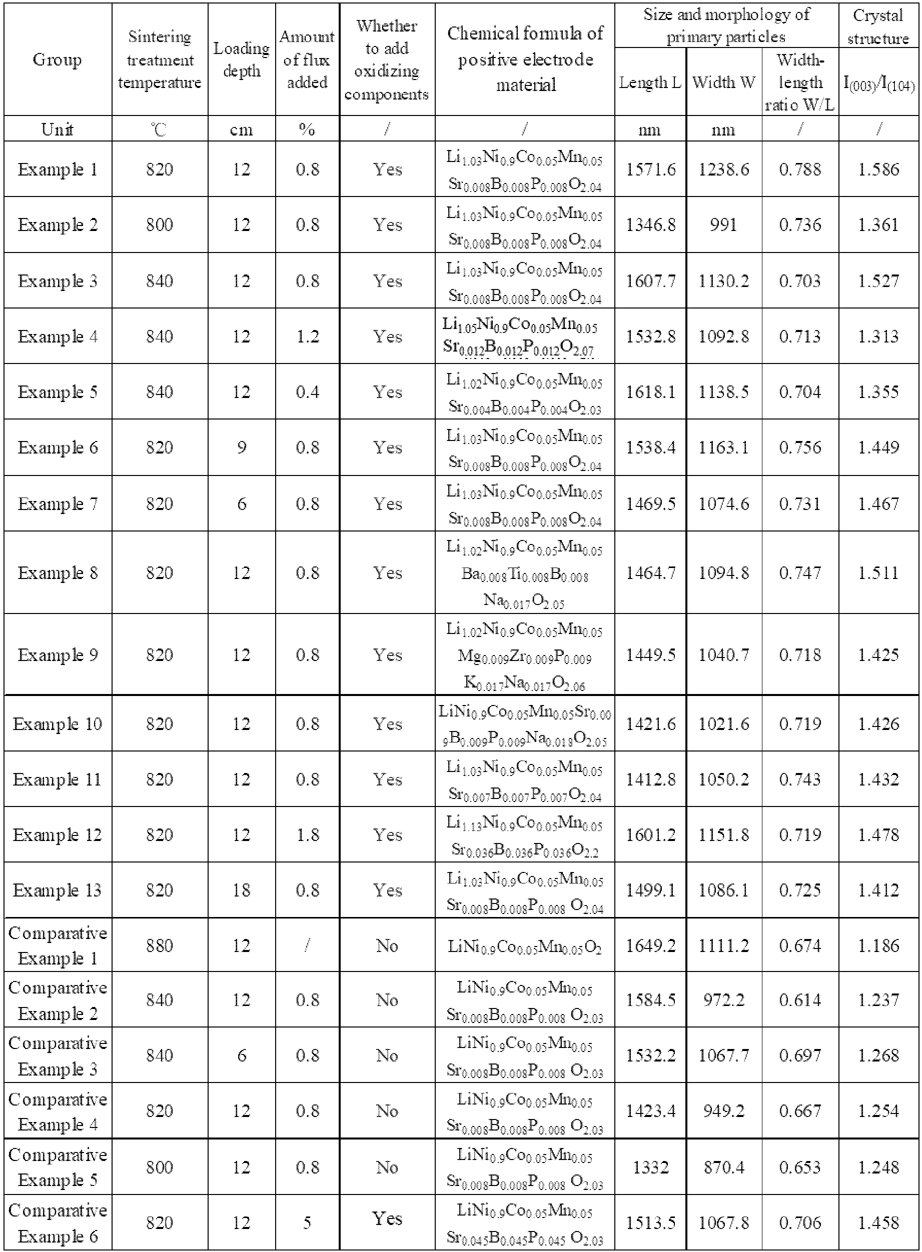

### III. Test of the surface chemical valence state of the positive electrode material

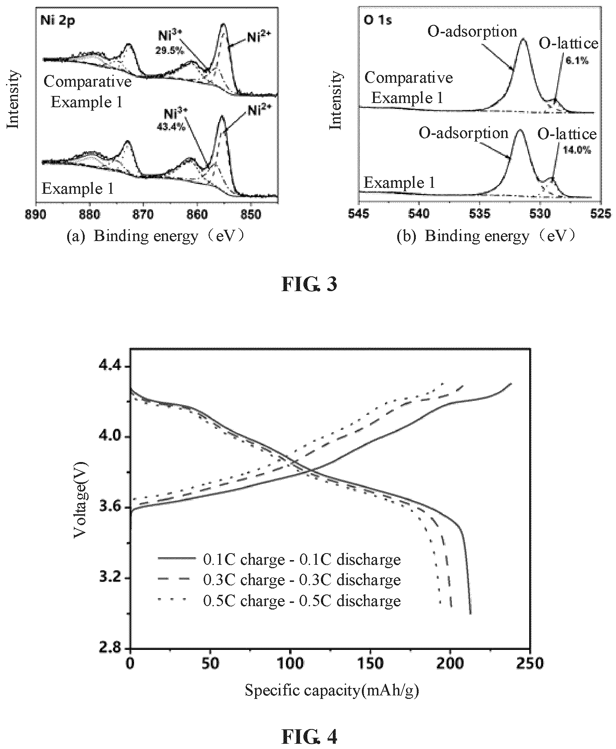

The positive electrode material was tested by X-ray photoelectron spectrometer (XPS). Al-Kα was used as the ray source (energy hv = 1486.6 eV), and C1s peak binding energy 284.80 eV was used as the charge correction standard. The two groups of Ni2p and O1s fine spectra were further analyzed, and deconvolution was performed according to the unified characteristic peak position to obtain the relative proportions of the following chemical states, among which the characteristic peak positions of Ni²⁺, Ni³⁺, O_{adsorption}, and O_{lattice} were limited to 855.1±0.1 eV, 856.5±0.1 eV, 531.6±0.1 eV, and 529.0±0.1 eV, respectively. The ratios of Ni³⁺/(Ni³⁺ + Ni²⁺) and O_{adsorption} /(O_{adsorption} + O_{lattice}) reflect the degree of nickel reduction and lattice oxygen evolution, and the results are shown in Table 2. The Ni 2p and O 1s fine spectra of Example 1 and Comparative Example 1 are shown in FIG 3. FIG 3(a) shows the Ni 2p fine spectra of Example 1 and Comparative Example 1, and FIG 3 (b) shows the O 1s fine spectra of Example 1 and Comparative Example 1.

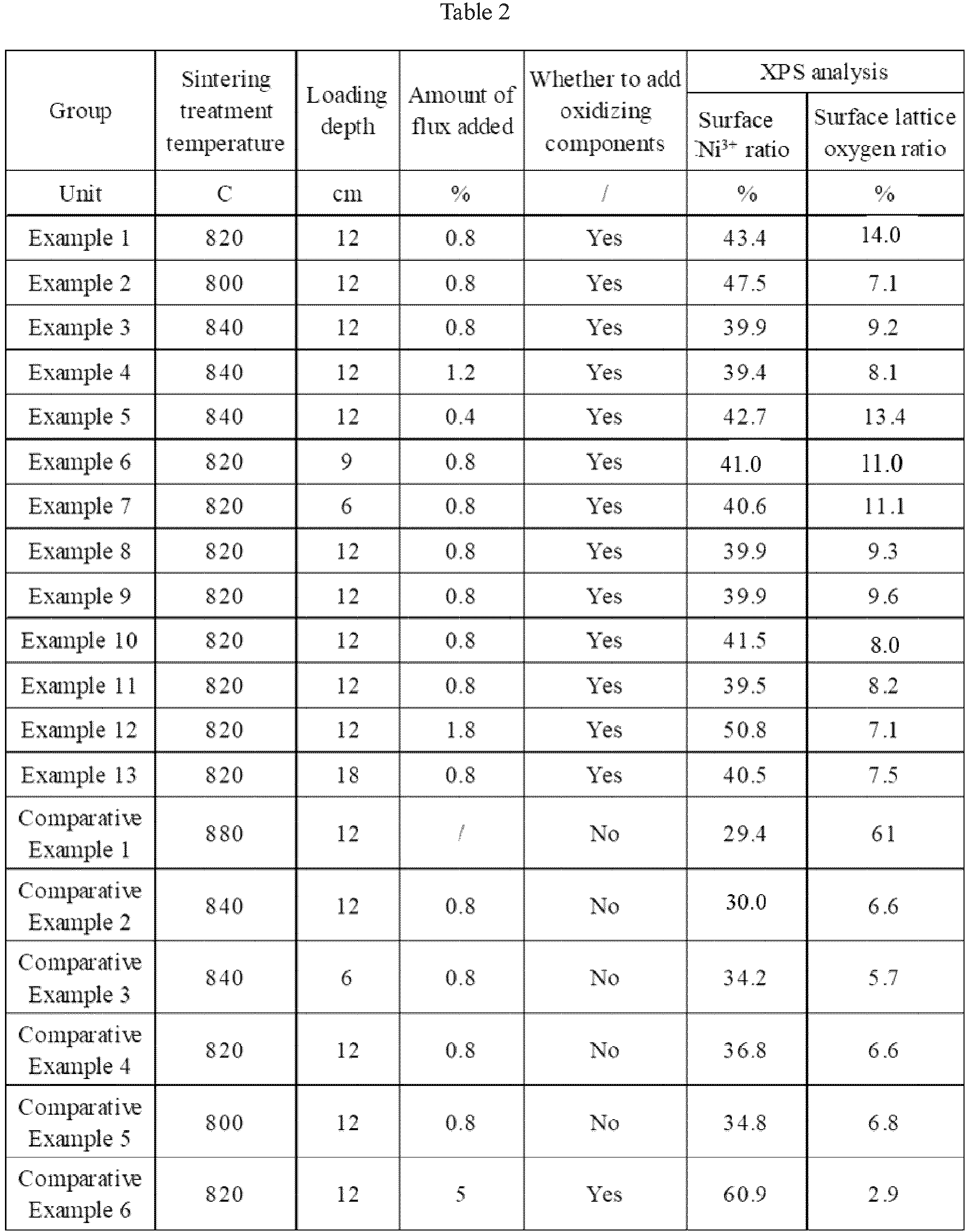

From the results in Table 2, it can be seen that the molar ratio of surface Ni³⁺ of Examples 1-13 is higher than that of Comparative Examples 1-5. In addition, the molar ratio of surface lattice oxygen of the Examples is generally higher than that of the Comparative Examples, indicating that the local oxygen supplement flux plays a role in inhibiting nickel reduction and oxygen evolution, especially when the material depth is large.

In Comparative Example 6, the molar ratio of surface Ni³⁺ is the highest, while the molar ratio of surface lattice oxygen is the lowest. The possible reason is that excessive addition of the local oxygen supplement flux leads to excessive amount of surface attachments (reflected as adsorbed oxygen in the O 1s spectrum of XPS), which increases the relative proportion of adsorbed oxygen in the test results and reduces the relative proportion of lattice oxygen.

### IV. Electrochemical performance test

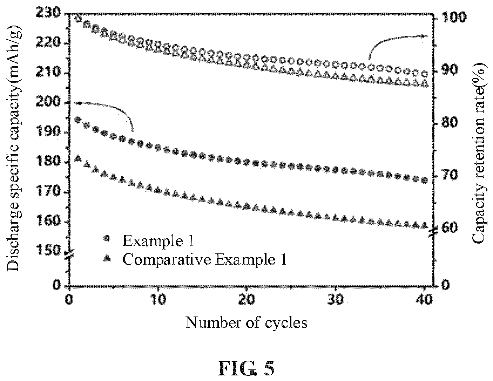

The positive electrode material, PVDF binder, conductive carbon black and N-methylpyrrolidone solvent were fully stirred and mixed in a mass ratio of 100:4.3:3.8:137 to form a uniform slurry, the slurry was evenly coated on one side of an aluminum foil, and the coated aluminum foil was dried, compacted and punched to obtain a positive electrode sheet (compacted density of 3.2 g/cm³) for a button cell. It was used as the positive electrode, and combined with a lithium sheet as the negative electrode, to assemble a button cell. The electrolyte was 1M LiPF₆ (EC/DMC, volume ratio of 1:1) solution. The charge/discharge specific capacity and cycle performance tests were carried out at room temperature, with a voltage range of 3.0 V-4.3 V. The results are shown in Table 3. The charge/discharge curve of Example 1 is shown in FIG 4. The cycle performance results of Example 1 and Comparative Example 1 are shown in FIG 5.

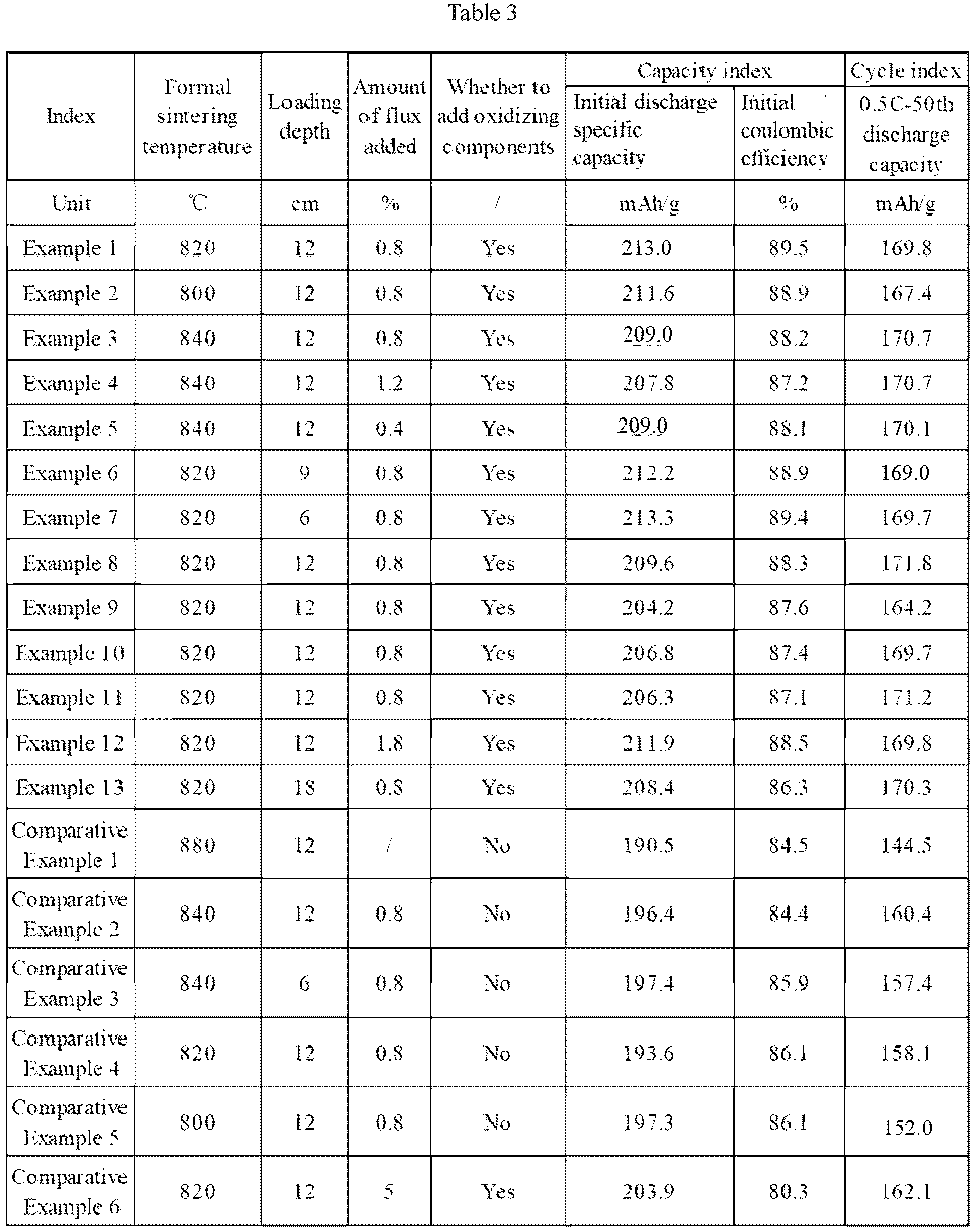

It can be seen from the results in Tables 1-3 that the high-nickel single crystal positive electrode material provided by the present application has a high molar ratio of surface Ni³⁺ and a high molar ratio of surface lattice oxygen, which are 38%-55% and 7%-15%, respectively. The length L and W of the primary particles of the material satisfy 0.7≤W/L≤0.85, and the ratio I₍₀₀₃₎/I₍₁₀₄₎ of the diffraction peak intensity of the crystal plane (003) and the crystal plane (104) in the XRD pattern of the material is 1.3-2. This indicates the structural defects of the high-nickel single crystal positive electrode material are significantly reduced, the particle morphology and crystal structure are significantly improved, and the reversible capacity and cycle stability are significantly enhanced.

The technical features of the above-described examples may be arbitrarily combined. To make the description concise, not all possible combinations of the technical features in the above-described examples are described. However, as long as there is no contradiction in the combination of these technical features, they should be considered to be within the scope of this specification.

The above-mentioned examples only express several embodiments of the present application, and the descriptions thereof are relatively specific and detailed, but they cannot be understood as limiting the scope of the disclosure patent. It should be noted that, for a person of ordinary skill in the art, several variations and modifications can be made without departing from the concept of the present application, and these all belong to the protection scope of the present application. Therefore, the protection scope of the patent of the present application shall be subject to the attached claims.

## Claims

1. A high-nickel single crystal positive electrode material, having a chemical formula of Li_{1+δ}NiₓM_{y}Q_{1-x-y}O_{2+ε}A_{α}R_{β}X_{γ}, wherein 0.8≤x<1, 0<y≤0.2, 0≤δ≤0.15, 0<ε≤0.2, 0<α≤0.04, 0<β≤0.04, 0≤γ≤0.04, the M element and the Q element each independently include one or more of Mn, Co, Al, Ta, Ti, Nb, Ge, Y, W, Zr, Ce, Ca, Sr, Sc, V, Cr and Mo; the A element includes one or more of Mg, Ca, Sr, Ba, Ti, Zr, V, Nb, Ta, Mo, W, La, Ce, Sc and Cr; the R element includes one or more of B and P; the X element includes one or more of Na, K, Mn, Mg, Ca, Sr and Al; a molar ratio of surface Ni³⁺ of the high-nickel single crystal positive electrode material is 38%-55%, and a molar ratio of surface lattice oxygen is 7%-15%.

2. The high-nickel single crystal positive electrode material according to claim 1, wherein a primary particle of the high-nickel single crystal positive electrode material has a length expressed as L and a width expressed as W, and W/L is 0.7-0.85;
optionally, L is 1300 nm-2000 nm;
optionally, W is 900 nm-1500 nm.

3. The high-nickel single crystal positive electrode material according to any one of claims 1 to 2, wherein in an XRD spectrum of the high-nickel single crystal positive electrode material, the diffraction peak intensities I₍₀₀₃₎ and I₍₁₀₄₎ of crystal plane (003) and crystal plane (104) satisfy a relationship of 1.3≤I₍₀₀₃₎/I₍₁₀₄₎≤2.

4. A method for producing a high-nickel single crystal positive electrode material according to any one of claims 1 to 3, comprising:
producing a local oxygen supplement flux comprising a basic flux component and an oxidizing component; wherein the oxidizing component generates an oxidizing gas under heating conditions, the elements contained in the basic flux component comprises the A element and the R element, and the elements contained in the oxidizing component comprises the X element;
subjecting a powder mixture comprising a lithium source and a precursor to a pre-sintering treatment to produce a pre-sintered material; wherein the precursor has a chemical formula of Ni_{c}MₐQ_{1-c-d}(OH)₂, wherein 0.8≤c<1, 0<d≤0.2, and the M element and the Q element each independently include one or more of Mn, Co, Al, Ta, Ti, Nb, Ge, Y, W, Zr, Ce, Ca, Sr, Sc, V, Cr and Mo;
mixing the local oxygen supplement flux and the pre-sintered material to obtain a mixture, and placing the mixture in a sample container for a sintering treatment to produce the high-nickel single crystal positive electrode material;
wherein the mass of the local oxygen supplement flux accounts for 0.1%-4% of the mass of the pre-sintered material.

5. The method according to claim 4, wherein the oxidizing component includes one or more of peroxide, superoxide, nitrate, nitrite, hypochlorite, chlorate, perchlorate, manganate and permanganate of Z element, and the Z element includes one or more of Li, Na, K, Mg, Ca, Sr and Al; and/or
the basic flux component includes one or more of type a flux and type b flux; the type a flux includes one or more of oxide, hydroxide, carbonate, sulfate, chloride and lithium oxygen compound containing the A element, and the A element includes one or more of Mg, Ca, Sr, Ba, Ti, Zr, V, Nb, Ta, Mo, W, La, Ce, Sc and Cr; the type b flux includes one or more of oxygen-containing acid and oxygen-containing acid salt containing boron or phosphorus element;
optionally, a molar ratio of the total of A element, boron element and phosphorus element contained in the basic flux component to the total of the Z element contained in the oxidizing component is (0.5-1.5):1.

6. The method according to any one of claims 4 to 5, wherein the pre-sintering treatment comprises at least one of conditions (1) to (6):
(1) the lithium source includes one or more of lithium hydroxide monohydrate, anhydrous lithium hydroxide, lithium carbonate, lithium nitrate, lithium oxide, lithium oxalate, lithium fluoride, lithium chloride, lithium acetate, lithium sulfate and lithium phosphate;
(2) a molar ratio of lithium element contained in the lithium source to the total metal element contained in the precursor is (0.95-1.20):1, optionally (1.01-1.11):1;
(3) the pre-sintering treatment is performed at a temperature of 500°C-700°C, optionally 600°C-700°C;
(4) the pre-sintering treatment is performed for 2 h-7 h, optionally 4 h-6 h;
(5) the pre-sintering treatment is performed at a heating rate of 2°C/min-20°C/min, optionally 3°C/min-10°C/min;
(6) the pre-sintering treatment is performed under an atmosphere including one or more of air and oxygen, optionally air.

7. The method according to any one of claims 4 to 5, wherein the sintering treatment comprises at least one of the conditions (1) to (6):
(1) a stacking depth of the pre-sintered material in the sample container is 1 cm-30 cm, optionally 8 cm-20 cm;
(2) the mass of the local oxygen supplement flux accounts for 0.3%-1.8% of the mass of the pre-sintered material;
(3) the sintering treatment is performed at a temperature of 700°C-1000°C, optionally 750°C-850°C;
(4) the sintering treatment is performed for 6 h-20 h, optionally 10 h-14 h;
(5) the sintering treatment is performed at a heating rate of 2°C/min-15°C/min, optionally 3°C/min-10°C/min;
(6) the sintering treatment is performed under an atmosphere including one or more of air and oxygen, optionally air.

8. A positive electrode sheet, comprising the high-nickel single crystal positive electrode material according to any one of claims 1 to 3 or the high-nickel single crystal positive electrode material produced by the method according to any one of claims 4 to 7.

9. A secondary battery, comprising the positive electrode sheet according to claim 8.

10. An electrical device, comprising the secondary battery according to claim 9.
